# EUROPEAN PATENT APPLICATION

(11) **EP 4 386 836 A1**
(43) Date of publication of application: **19.06.2024**
(21) Application number: 23164715.7
(22) Date of filing: 28.03.2023
(51) Int. Cl.: H01L 23/538

(54) **INTERPOSER WITH INTEGRATIVE PASSIVE COMPONENTS**

(30) Priority: 16.12.2022 US 202218067649
(71) Applicant: NXP USA, Inc., Austin TX 78735 (US)
(72) Inventor: Gong, Zhiwei, 5656AG Eindhoven (NL); Acar, Mustafa, 5656AG Eindhoven (NL); Zhou, Tingdong, 5656AG Eindhoven (NL); Wenzel, Robert Joseph, 5656AG Eindhoven (NL)
(74) Representative: Miles, John Richard

(57) **Abstract**

An interposer may include one or more passive components integrated within a dielectric substrate and may include one or more three-dimensional (3D) connectors that surround respective portions of the dielectric substrate. Component terminals of the one or more passive components may each be disposed on the same side of the interposer. For example, the interposer may be disposed between a first package and a second package, such that the connectors of the interposer electrically connect the first package to the second package. The component terminals of the one or more passive components may couple the integrated passive components of the interposer to only one package to which the interposer is coupled.

## Description

### TECHNICAL FIELD

Embodiments of the subject matter described herein relate generally to electronic device packages and, more specifically, to electronic device packages that include interposers with integrated passive components.

### BACKGROUND

As the size of electronic components becomes smaller, and as the size of devices containing those electronic components also decreases, density demands for electronic chip packaging become greater. This trend toward package miniaturization typically requires higher-level integration, higher package density, and tighter spacing of components and modules of packages. However, conventional discrete passive components tend to have undesirably large footprints and typically require relatively large amounts of keep out space (in some cases exceeding 1 mm) separating such components from surrounding components.

### SUMMARY

A brief summary of various exemplary embodiments is presented below. Some simplifications and omissions may be made in the following summary, which is intended to highlight and introduce some aspects of the various exemplary embodiments, without limiting the scope. Detailed descriptions of an exemplary embodiment adequate to allow those of ordinary skill in the art to make and use these concepts will follow in later sections.

In an example embodiment, a package module includes an interposer, a first substrate, and a second substrate. The interposer includes a dielectric substrate, at least one connector disposed on at least one surface of the dielectric substrate, at least one passive component embedded in the dielectric substrate, and at least two component terminals disposed at a same side of the dielectric substrate and coupled to the at least one passive component. The first substrate is disposed on the interposer and in electrical contact with the at least one connector of the interposer. The interposer is disposed on the second substrate, where the second substrate is in electrical contact with the at least one connector of the interposer and with the at least two component terminals of the interposer.

In one or more embodiments, the at least one connector includes a first connector disposed on a first surface of the dielectric substrate and a second connector disposed on a second surface of the dielectric substrate that is opposite the second surface, where the first connector extends from the first substrate to the second substrate, and the second connector extends from the first substrate to the second substrate.

In one or more embodiments, each of the at least two component terminals of the interposer is isolated from the first connector and the second connector of the interposer.

In one or more embodiments, the at least two component terminals of the interposer include a first component terminal and a second component terminal, the first component terminal of the interposer is integrally formed with the first connector of the interposer, and the second component terminal of the interposer is isolated from the second connector of the interposer.

In one or more embodiments, the at least one passive component includes a first passive component and a second passive component; the at least one connector includes a first connector, a second connector, and a third connector, and the at least two component terminals include first and second component terminals coupled between the first passive component and the second substrate, and third and fourth component terminals coupled between the second passive component and the second substrate.

In one or more embodiments, the first connector is disposed on a first surface of the dielectric substrate, the second connector is disposed on a second surface of the dielectric substrate that is opposite the first surface, and the third connector is wrapped at least partially around the dielectric substrate such that the third connector is in contact with third, fourth, and fifth surfaces of the dielectric substrate, which each extend between the first surface and the second surface.

In one or more embodiments, the first connector extends between a first conductive layer of the first substrate and a first conductive layer of the second substrate, such that the first connector electrically connects the first substrate to the second substrate, the second connector extends between a second conductive layer of the first substrate and a second conductive layer of the second substrate, such that the second connector electrically connects the first substrate to the second substrate, and the third connector extends between a third conductive layer of the first substrate and a third conductive layer of the second substrate, such that the third connector electrically connects the first substrate to the second substrate.

In one or more embodiments, outermost conductive layers of each of the at least one connector and the at least two component terminals each include solder.

In one or more embodiments, a ball grid array includes a plurality of elements that includes a plurality of solder balls and the interposer. The ball grid array is disposed between the first substrate and the second substrate.

In an example embodiment, an interposer includes a dielectric substrate, at least one connector disposed on at least one surface of the dielectric substrate, at least one passive component embedded in the dielectric substrate, and at least two component terminals disposed at a same side of the dielectric substrate and coupled to the at least one passive component.

In one or more embodiments, the at least one connector includes a first connector disposed on a first surface of the dielectric substrate and a second connector disposed on a second surface of the dielectric substrate that is opposite the second surface.

In one or more embodiments, each of the at least two component terminals is isolated from the first connector and the second connector.

In one or more embodiments, the at least two component terminals of the interposer include a first component terminal and a second component terminal, the first component terminal is integrally formed with the first connector, and the second component terminal is isolated from the second connector.

In one or more embodiments, the at least one passive component includes a first passive component and a second passive component, the at least one connector includes a first connector, a second connector, and a third connector, the at least two component terminals includes first, second, third, and fourth component terminals, each disposed at the same side of the dielectric substrate, and the first and second component terminals coupled to the first passive component, and the third and fourth component terminals are coupled to the second passive component.

In one or more embodiments, the first connector is disposed on a first surface of the dielectric substrate, the second connector is disposed on a second surface of the dielectric substrate that is opposite the first surface, and the third connector is wrapped at least partially around the dielectric substrate such that the third connector is in contact with third, fourth, and fifth surfaces of the dielectric substrate, which each extend between the first surface and the second surface.

In one or more embodiments, outermost conductive layers of each of the at least one connector and the at least two component terminals each include solder.

In an example embodiment, a package module includes an interposer and a first package substrate. The interposer includes a dielectric substrate, a first connector disposed on a first surface of the dielectric substrate, a second connector disposed on a second surface of the dielectric substrate, where the second surface of the dielectric substrate is opposite the first surface of the dielectric substrate, at least one passive component embedded in the dielectric substrate, a first component terminal disposed on a third surface of the dielectric substrate and coupled to the at least one passive component, and a second component terminal disposed on the third surface of the dielectric substrate and coupled to the at least one passive component. The first package substrate is in electrical contact with the first and second connectors of the interposer.

In one or more embodiments, the package module includes mold material in which the interposer is embedded and an integrated circuit die disposed over the mold material, where the first package substrate is coupled to the integrated circuit die via the first and second connectors of the interposer.

In one or more embodiments, the package module includes a second package substrate in electrical contact with the first and second connectors of the interposer and with the first and second component terminals of the interposer. The first connector extends from the first package substrate to the second package substrate, and the second connector extends from the first package substrate to the second package substrate.

In one or more embodiments, the package module includes a third connector that extends between the first package substrate and the second package substrate, a third component terminal disposed on the third surface of the dielectric substrate, a fourth component terminal disposed on the third surface of the dielectric substrate, and a second passive component coupled to the third component terminal and the fourth component terminal. The third connector includes portions that directly contact the third surface of the dielectric substrate, a fourth surface of the dielectric substrate, and a fifth surface of the dielectric substrate. The third, fourth, and fifth surfaces of the dielectric substrate extend between the first and second surfaces of the dielectric substrate. Each of the first, second, third, and fourth component terminals contact respectively different conductive layers of the second package substrate.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a cross-sectional side view of a package module that includes an interposer having an integrated passive component and three-dimensional (3D) connectors that electrically couple a first package substrate to a second package substrate, in accordance with various embodiments;
FIGS. 2A and 2B show perspective and cross-sectional views of an interposer that includes an integrated capacitor, in accordance with various embodiments;
FIG. 3 is a cross-sectional side view of an interposer that includes an integrated capacitor, where a component terminal of the integrated capacitor is connected to a connector of the capacitor, in accordance with various embodiments;
FIGS. 4A and 4B show top-down and cross-sectional views of an interposer that includes an integrated inductor, in accordance with various embodiments;
FIG. 5 is a cross-sectional side view of an interposer that includes an integrated resistor, in accordance with various embodiments;
FIG. 6 is a cross-sectional side view of a package module that includes an interposer having at least two integrated passive components and three-dimensional (3D) connectors that electrically couple a first package substrate to a second package substrate, in accordance with various embodiments;
FIG. 7A and 7B show perspective and cross-sectional views of an interposer that includes two integrated capacitors, in accordance with various embodiments;
FIG. 8 shows a top-down view of an interposer that includes eight integrated passive components and six connectors, in accordance with various embodiments;
FIG. 9 is a cross-sectional side view of a package module that includes an interposer embedded in mold material at a surface of a package substrate, where the interposer includes an integrated passive component electrically coupled to the package substrate and connectors that couple the package substrate to one or more elements through the mold material, in accordance with various embodiments; and
FIG. 10 is a cross-sectional top-down view of a package module that includes a ball grid array in which one or more elements of the ball grid array are interposers, such as the interposers of any of the examples of FIGS. 1-9, rather than solder balls, in accordance with various embodiments.

### DETAILED DESCRIPTION

The following detailed description is merely illustrative in nature and is not intended to limit the embodiments of the subject matter or the application and uses of such embodiments. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose. As used herein, the words "exemplary" and "example" mean "serving as an example, instance, or illustration." Any implementation described herein as exemplary or an example is not necessarily to be construed as preferred or advantageous over other implementations.

Directional references such as "top," "bottom," "left," "right," "above," "below," and so forth, unless otherwise stated, are not intended to require any preferred orientation and are made with reference to the orientation of the corresponding figure or figures for purposes of illustration.

For the sake of brevity, conventional semiconductor fabrication techniques may not be described in detail herein. In addition, certain terms may also be used herein for reference only, and thus are not intended to be limiting. For instance, the terms "first", "second", and other such numerical terms referring to structures do not imply a sequence or order unless clearly indicated by the context.

Passive components are routinely required for electronic device packages or modules. However, conventional discrete passive components tend to have undesirably large footprints while only serving their inherent function (as a capacitor, inductor, resistor, etc.). Additionally, for multi-chip or multi-package assemblies that require underfill, the amount of keep out space required between conventional discrete passive components and surrounding elements (other passive components, solder balls, die, etc.) may be in the hundreds of microns.

Various embodiments described herein relate to interposers that include one or more integrated passive components (e.g., capacitors, inductors, resistors and/or the like) in a dielectric substrate, three-dimensional (3D) connectors disposed around (e.g., not through) portions of the dielectric substrate, and component terminal connectors disposed at one (e.g., only one) side of the dielectric substrate. Such interposers may combine the functionality of multiple discrete components (e.g., capacitors, inductors, resistors, solder balls, solder bumps, and/or the like) into a more compact form factor. For example, such an interposer that includes an integrated capacitor and that is disposed between a first package substrate and a second package substrate may provide both the passive function of the integrated capacitor while also providing electrical connections between the first package substrate and the second package substrate. Such an interposer, in accordance with embodiments described herein, may advantageously have a reduced physical footprint and reduced vertical height compared to those of the combination of discrete elements (e.g., capacitors, inductors, resistors, solder balls, solder bumps, and/or the like) that would otherwise be required to perform corresponding functions.

In one or more embodiments, an interposer with integrated passive components and connectors may be included in a package module that includes multi-chip or multi-package substrates (e.g., a package-on-package (PoP) module) in which the interposer may be coupled between a first package substrate and a second package substrate, such that the connectors of the interposer electrically couple the first package substrate to the second package substrate. In one or more embodiments, one or more of the component terminals coupled to one or more passive components integrated within the interposer may be coupled to contacts at the surface of only one of the first package substrate and the second package substrate. In one or more embodiments, at least one component terminal of the interposer may be coupled to (e.g., directly connected to) one of the connectors of the interposer (e.g., to provide a connection to ground for one or more passive components of the interposer).

In one or more embodiments, the interposer may be included at a surface of disposed in mold material at a surface of a package, where the connectors of the interposer may electrically couple the package to one or more die (e.g., integrated circuit die) or other elements disposed over the mold material. For example, the connectors of the interposer may act as through-mold vias (TMVs) that extend through the mold material. In one or more embodiments, the die or other elements may be coupled to the connectors of the interposer via one or more solder balls or solder bumps.

According to various embodiments, the integrated passive component(s) of the interposer may include one or more capacitors, resistors, or inductors, each having terminals coupled to component terminal connectors disposed at only one side (i.e., one surface) of the dielectric substrate of the interposer. In one or more embodiments, a first connector of the interposer may form a first cap covering a first end of the dielectric substrate of the interposer and a second connector of the interposer may form a second cap covering a second end of the dielectric substrate of the interposer that is opposite the first end. That is, the first connector may be formed directly on a first end surface of the dielectric substrate of the interposer and directly on portions of the four side surfaces of the dielectric substrate that are immediately adjacent to the first end surface. Similarly, the second connector may be formed directly on a second end surface of the dielectric substrate of the interposer (opposite the first end surface) and directly on portions of the four side surfaces of the dielectric substrate that are immediately adjacent to the second end surface. In one or more embodiments, the interposer may include a third connector that encircles the four side surfaces of the dielectric substrate. In one or more other embodiments, the interposer may include six or more connectors, each wrapped partially around the dielectric substrate so as to be coupled to at least three surfaces of the substrate.

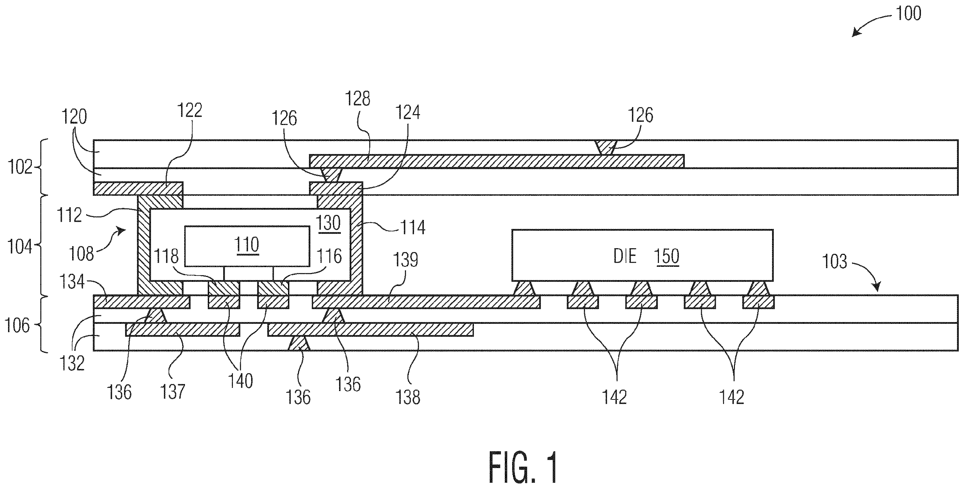

FIG. 1 shows an example package module 100 that includes a first package substrate 102 disposed over (e.g., stacked on) a second package substrate 106, where at least one interposer 108 is disposed in an inter-package region 104 between the first package substrate 102 and the second package substrate 106. The package module 100 may have a package-on-package (PoP) arrangement, as a non-limiting example. The interposer 108 may include connectors 112 and 114 that provide both structural and electrical connections between the first package substrate 102 and the second package substrate 106. The connectors 112, 114 may be 3D connectors that are disposed on multiple sides of a dielectric substrate 130 of the interposer 108. Herein, a "3D connector" refers to electrically conductive material that provides a vertical connection between conductive elements (e.g., conductive layers, solder balls, or other suitable electrically conductive packaging elements), such as conductive elements that are disposed in different package layers or different package substrates. Here, a "vertical connection" refers to a connection between two elements that are spatially separated at least with respect to a "z-direction", where the z-direction refers to a direction that is normal to the plane of the package surface (e.g., a surface 103 of the second package substrate 106 in the present example). The interposer 108 may include an integrated passive component 110 that is coupled to the second package substrate 106 via component terminals 116 and 118 that are each disposed on the same side of the interposer 108.

In one or more embodiments, the first package substrate 102 and the second package substrate 106 may be printed circuit board (PCB) substrates. The first package substrate 102 may include multiple dielectric layers 120 on or in which conductive (i.e., electrically conductive) layers, such as conductive layers 122, 124, 128, are embedded or disposed. Various conductive layers of the first package substrate 102, such as the conductive layers 122, 124, 128 may be electrically coupled together by one or more electrically conductive vias 126 that each via extends partially or completely through one or more of the dielectric layers 120.

The second package substrate 106 may include multiple dielectric layers 132 on or in which conductive layers, such as conductive layers 134, 137, 138, 139, 140, 142 are embedded or disposed. Various conductive layers of the second package substrate 106, such as the conductive layers 134, 137, 138, 139, 140, 142 may be electrically coupled together by one or more electrically conductive vias 136 that each via extends partially or completely through one or more of the dielectric layers 132. Each of the conductive layers 122, 124, 128, 134, 137, 138, 139, 140, 142 and the conductive vias 126, 136 may be formed from or may include one or more layers of conductive material, such as gold, copper, aluminum, nickel, or a combination of these, or electrically conductive paste that includes one or more such conductive materials, as non-limiting examples. Each of the dielectric layers 120, 132 may be formed from dielectric material such as epoxy resin, glass, alumina, polytetrafluoroethylene (PTFE), or any suitable combination (e.g., composite) of these, as non-limiting examples.

The interposer 108 may include connectors 112, 114, a dielectric substrate 130, a passive component 110, and component terminals 116, 118. In one or more embodiments, each of the connectors 112, 114 and the component terminals 116, 118 may include one or more layers of conductive material, such as gold, copper, aluminum, nickel, tin, or a combination of these, as non-limiting examples. In one or more embodiments, the outermost conductive layers of each of the connectors 112, 114 and the component terminals 116, 118 may include solder (e.g., a solder alloy including any suitable combination of tin, lead, silver, bismuth, antimony, indium, or cadmium as non-limiting examples), such that the connectors 112, 114 and the component terminals 116, 118 can be attached to corresponding conductive layers of the first package substrate 102 and/or the second package substrate 106 (e.g., via a solder reflow process). For example, each of the connectors 112, 114 and the component terminals 116, 118 may respectively include a copper layer formed on the dielectric substrate 130, a nickel layer formed on the copper layer, and a solder alloy layer formed on the nickel layer.

The connectors 112, 114 of the interposer 108 may be disposed on opposite ends of the dielectric substrate 130. For example, the connector 112 may be in direct contact with (e.g., fully covering) a first surface of the dielectric substrate 130 and in direct contact with portions of two or more surfaces of the dielectric substrate 130 that are immediately adjacent to the first surface. The connector 114 may be in direct contact with (e.g., fully covering) a second surface of the dielectric substrate 130 that is opposite the first surface and in direct contact with portions of two or more surfaces of the dielectric substrate 130 that are immediately adjacent to the second surface. In one or more embodiments, each of the connectors 112, 114 may form first and second conductive caps that cover the opposite ends of the dielectric substrate 130.

In the present example, the connector 112 may have a first end that directly contacts and that is electrically coupled to the conductive layer 122 of the first package substrate 102 and may have a second end that directly contacts and that is electrically coupled to the conductive layer 134 of the second package substrate 106. In this way, the connector 112 may electrically couple the first package substrate 102 to the second package substrate 106.

The connector 114 may have a first end that directly contacts and that is electrically coupled to the conductive layer 124 of the first package substrate 102 and may have a second end that directly contacts and that is electrically coupled to the conductive layer 139 of the second package substrate 106. In this way, the connector 114 may electrically couple the first package substrate 102 to the second package substrate 106.

The component terminals 116, 118 may be coupled to the second package substrate through directly contact with respective conductive layers 140 of the second package substrate 106. In one or more embodiments, the component terminals 116, 118 may be formed on the same side of the dielectric substrate 130, such that the passive component 110 is only directly connected to the second package substrate 106. For example, providing the component terminals 116, 118 on the same surface of the dielectric substrate 130, may provide additional space for the connectors 112, 114 on other surfaces of the dielectric substrate 130. In one or more other embodiments, other arrangements of component terminals may be used. For example, in one or more such embodiments, at least one component terminal disposed at a top surface of the dielectric substrate 130 and at least one component terminal disposed at a bottom surface of the dielectric substrate 130, such that the passive component 110 is coupled to the first package substrate 102 and the second package substrate 106 while the connectors 112 and 114 may still electrically couple the first package substrate 102 to the second package substrate 106.

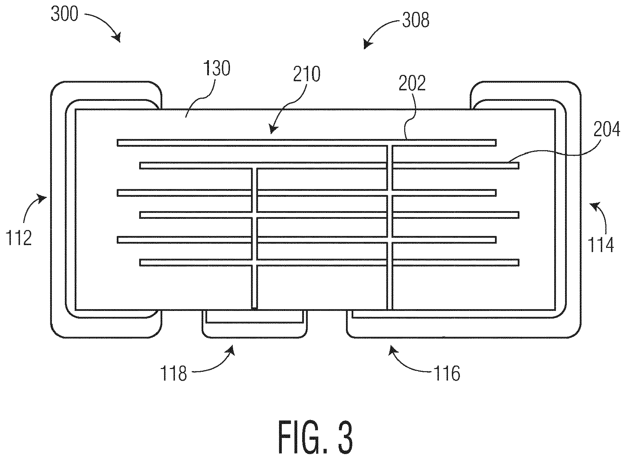

While the component terminals 116, 118 are each shown to be separate from (e.g., isolated from) the connectors 112, 114 in the present example, in one or more other embodiments, the component terminal 116 may be coupled to the connector 114. In one or more such other embodiments, the component terminal 116 may be integrally formed with the connector 114 (e.g., as shown in the example of the interposer 308 of FIG. 3).

According to various embodiments, the passive component 110 may include a capacitor, an inductor, a resistor, or any other suitable passive component. The passive component 110 may have a first terminal coupled to the component terminal 116 and a second terminal coupled to the component terminal 118, such that the passive component 110 is effectively coupled between the component terminal 116 and the component terminal 118. In one or more embodiments, conductive elements of the passive component 110 may include nickel or other suitable conductive material. In one or more embodiments, the conductive elements of the passive component 110 may be embedded or otherwise formed in the dielectric substrate 130. In one or more embodiments, the dielectric substrate 130 may include dielectric material, such as ceramic dielectric material (e.g., calcium zirconium oxide or barium titanate as non-limiting examples), film, carbon, metal-oxide film, or other suitable dielectric material as non-limiting examples.

The interposer 108 may be disposed in the inter-package region 104 between the first package substrate 102 and the second package substrate 106. In addition to the interposer 108, other components may be disposed in the inter-package region 104, such as additional interposers, solder balls (e.g., as part of a ball grid array), one or more integrated circuit die, such as an integrated circuit die 150 (e.g., coupled to conductive layers 142 of the second package substrate 106), and/or one or more passive components (e.g., surface mount device components, which may include capacitors, inductors, or resistors) as non-limiting examples. In one or more embodiments, underfill material may be provided in the spaces between components in the inter-package region 104. In one or more other embodiments, no such underfill material is provided such that components in the inter-package region 104 are separated by air. In one or more other embodiments, the inter-package region 104 may correspond to a core layer of a package substrate in which the interposer 108 is embedded.

In conventional systems, the function of connecting two substrates is typically performed by solder balls, while separate surface mount device (SMD) components are used to provide passive component functionality. In contrast, the interposer 108 provides both passive device functionality via the passive component 110 and package-to-package connections via the connectors 112, 114. The footprint required by a conventional combination of a solder ball (typically around 0.2 mm to 1 mm in diameter) and an adjacent SMD component (typically having a footprint area of 0.3 x 0.6 mm for 0201 SMD components), given a keep out area requirement of around 0.2 mm between the solder ball and SMD component, is typically a minimum of around 0.3 x 1 mm. In contrast, the footprint area of the interposer 108 may be around 0.2 x 0.4 mm. Thus, the interposer 108 may require a footprint area that is around 50% or less than that of such conventional discrete component arrangements. In this way, the size of the package module 100 may be decreased advantageously due, at least in part, to the comparatively compact footprint of the interposer 108.

Additionally, in conventional package modules with two substrates, placement of SMD components in an inter-package region requires the omission (depopulation) of one or more solder balls of a ball grid array that connects the two substrates. Removal of such solder balls in conventional package modules may negatively impact the mechanical stability of such conventional package substrates, which can lead to board level reliability (BLR) test failure or failure in the field (e.g., due to solder fatigue cracking). Removal of such solder balls in conventional package modules may additionally increase the complication of electrical routing between packages. In contrast, the passive component functionality may be included in the inter-package region 104 by the interposer 108 while also providing structural stability and electrical connections between the packages 102, 106 via the connectors 112, 114. For example, by providing the interposer 108 in place of one or more solder balls of a ball grid array, one or more passive components (e.g., the passive component 110) may be added to the inter-package region 104 without sacrificing the structural support and electrical connections that would have been provided by the solder ball(s) being replaced.

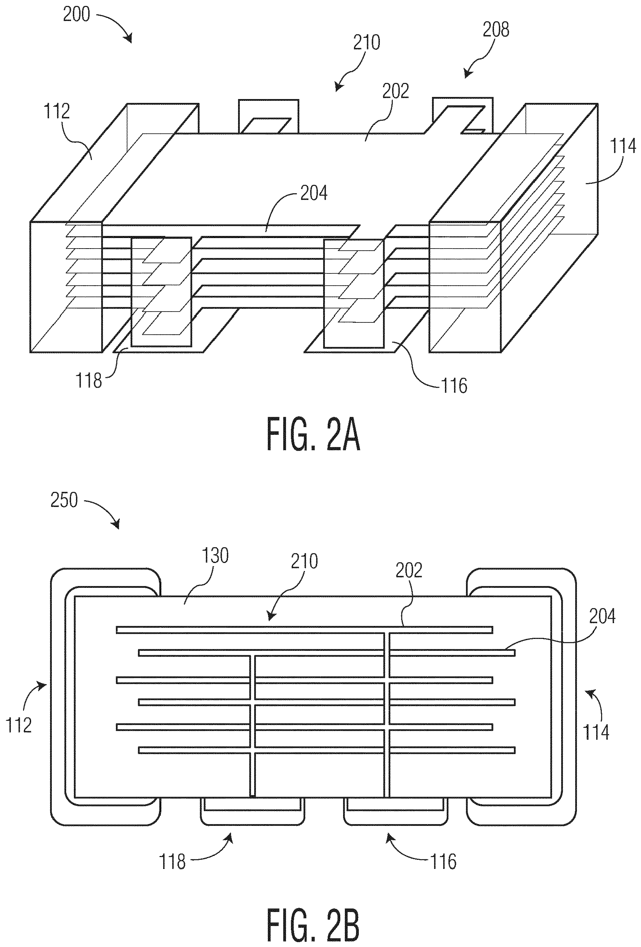

It should be understood that one or more of the advantages described above in relation to the interposer 108 may also apply one or more of the other embodiments described herein (e.g., the interposers 208, 408, 508, 608, 708, 808, 1008 of FIGS. 2A-10).

FIGS. 2A and 2B respectively show a partially transparent perspective view 200 and a cross-sectional side view 250 of an interposer 208, which may be an example embodiment of the interposer 108 of FIG. 1. One or more elements of the interposer 208 may be similar to elements of the interposer 108 of FIG. 1, with like elements being denoted using like reference numerals. Aspects of such like elements that are described above are not necessarily redescribed here for the sake of brevity.

As shown in the view 200, the interposer 208 includes a capacitor 210 (e.g., an example embodiment of the passive component 110 of FIG. 1) that is embedded in the dielectric substrate 130. It should be noted that the dielectric substrate 130 is not shown in the partially transparent perspective view 200 to allow other elements of the interposer 208 to be seen. The capacitor 210 may include a stack of parallel plates that includes a first group of parallel plates 202 and a second group of parallel plates 204 that are arranged in an alternating pattern, such that each of the first group of parallel plates 202 is capacitively coupled to at least one of the second group of parallel plates 204 and vice versa. The first group of parallel plates 202 and the second group of parallel plates 204 may each be formed from conductive material, which may be nickel, copper, gold, aluminum, or a combination of these, as non-limiting examples. Each parallel plate of the first group of parallel plates 202 may be electrically connected each other parallel plate of the first group of parallel plates 202 and to the component terminal 116. Each parallel plate of the second group of parallel plates 204 may be electrically connected to each other parallel plate of the second group of parallel plates 204 and the component terminal 118. The component terminals 116 and 118 may be isolated (e.g., not in direct contact with) the connectors 112, 114. As shown, the component terminals 116 and 118 may be disposed at the same side of the dielectric substrate 130.

FIG. 3 shows a cross-sectional side view 300 of an interposer 308, which may be an example embodiment of the interposer 108 of FIG. 1. One or more elements of the interposer 308 may be similar to elements of the interposer 108 of FIG. 1 and/or the interposer 208 of FIGS. 2A, 2B, with like elements being denoted using like reference numerals. Aspects of such like elements that are described above are not necessarily redescribed here for the sake of brevity.

Similar to the example of the interposer 208 of FIGS. 2A, 2B, the interposer 308 includes a capacitor 210 embedded in the dielectric substrate 130 and including a first group of parallel plates 202 that are coupled to the component terminal 116 and a second group of parallel plates that are coupled to the component terminal 118. In the interposer 308, the component terminal 118 may be isolated from the connectors 112, 114, while the component terminal 116 may be isolated from the connector 112 and electrically connected to the connector 114. In one or more embodiments, the component terminal 116 may be integrally formed with the connector 114.

By connecting the component terminal 116 to the connector 114 in this way may allow the capacitor 210 to be shunted to a signal path or reference voltage (e.g., ground) to which the connector 114 is coupled. For example, the connector 114 may be biased to a ground voltage (e.g., via a connection to one or more package substrates, such as the first package substrate 102 or the second package substrate 106 of FIG. 1), and one terminal the capacitor 210 may be grounded via the connection between the component terminal 116 and the connector 114, such that the capacitor 210 is shunted to ground.

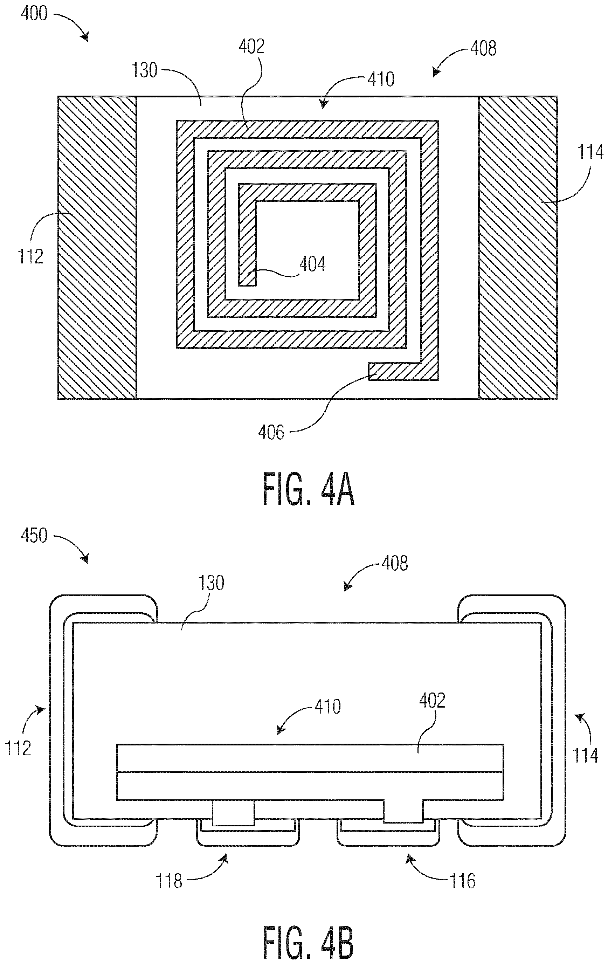

FIGS. 4A and 4B respectively show a cross-sectional top-down view 400 and a cross-sectional side view 450 of an interposer 408, which may be an example embodiment of the interposer 108 of FIG. 1. One or more elements of the interposer 408 may be similar to elements of the interposer 108 of FIG. 1, with like elements being denoted using like reference numerals. Aspects of such like elements that are described above are not necessarily redescribed here for the sake of brevity.

As shown in the view 400, the interposer 408 includes an inductor 410 (e.g., an example embodiment of the passive component 110 of FIG. 1) that is embedded in the dielectric substrate 130. The inductor 410 may be a planar spiral inductor that includes at least one spiral 402 having multiple windings. While the windings of the spiral 402 are each shown to define a substantially square perimeter in the present example, it should be understood that this is intended to be illustrative and not limiting, and the windings of the spiral 402 may have any suitable geometry in accordance with one or more other embodiments (e.g., with the spiral 402 including multiple connected concentric circular windings, rather than concentric square windings). The spiral 402 be formed from conductive material, which may be nickel, copper, gold, aluminum, or a combination of these, as non-limiting examples. The spiral 402 may have a first end 404 that is coupled to the component terminal 118 and a second end 406 that is coupled to the component terminal 116. In one or more embodiments, the inductor 410 may include multiple stacked planar spiral inductors in addition to the spiral 402. As shown, the component terminals 116 and 118 may be disposed at the same side of the dielectric substrate 130.

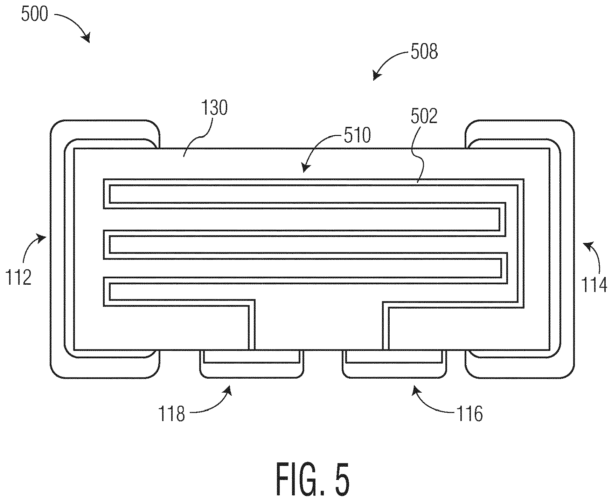

FIG. 5 shows a cross-sectional side view 500 of an interposer 508, which may be an example embodiment of the interposer 108 of FIG. 1. One or more elements of the interposer 508 may be similar to elements of the interposer 108 of FIG. 1, with like elements being denoted using like reference numerals. Aspects of such like elements that are described above are not necessarily redescribed here for the sake of brevity.

As shown in the view 500, the interposer 508 includes a resistor 510 (e.g., an example embodiment of the passive component 110 of FIG. 1) that is embedded in the dielectric substrate 130. In one or more embodiments, the resistor 510 may be a wire resistor that includes a wire 502 routed through the dielectric material and that connects the component terminal 116 to the component terminal 118. For example, the dimensions of the wire 502 of the resistor 510 (e.g., length and cross-sectional area) may be selected to provide a desired resistance between the component terminal 116 and the component terminal 118. The wire 502 of the resistor 510 may be formed from conductive material, which may be nickel, copper, gold, aluminum, or a combination of these, as non-limiting examples. As shown, the component terminals 116 and 118 may be disposed at the same side of the dielectric substrate 130.

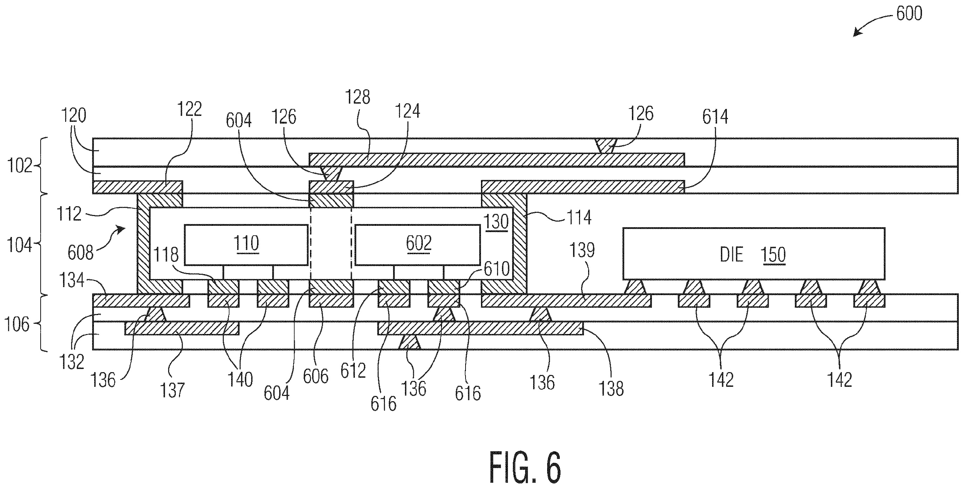

FIG. 6 shows an example package module 600 in which a first package substrate 102 is disposed over (e.g., stacked on) a second package substrate 106, where at least one interposer 608 having multiple passive components 110, 602 and at least three connectors 112, 114, 604 is disposed in an inter-package region 104 between the first package substrate 102 and the second package substrate 106. The package module 600 may have a PoP arrangement as a non-limiting example. One or more elements of the package module 600 may be similar to elements of the package module 100 of FIG. 1, with like elements being denoted using like reference numerals. Aspects of such like elements that are described above are not necessarily redescribed here for the sake of brevity.

The package module 600 may include an interposer 608 that is disposed in the inter-package region 104 between the first package substrate 102 and the second package substrate 106. The interposer 608 may include multiple passive components, such as the passive component 110 and a passive component 602, which may include any combination of resistors, capacitors, inductors, or other suitable passive components. The interposer 608 may include multiple connectors 112, 114, 604 that extend between the first package substrate 102 and the second package substrate 106. The connector 604 may be wrapped around three or more surfaces of the dielectric substrate 130, where the three or more surfaces extend between the two end surfaces of the dielectric substrate 130 on which the connectors 112, 114 are respectively disposed. That is, the connector 604 may not pass through the dielectric substrate 130, but instead may be disposed on only surfaces of the dielectric substrate 130. By wrapping the connector 604 around surfaces of the dielectric substrate 130, rather than providing a connector that passes directly through the dielectric substrate 130, the likelihood of accidental shorting between the connector 604 and the passive components 110, 602 may be comparatively reduced, which may reduce the amount of separation required between the connector 604 and the passive components 110, 602, resulting in a comparatively reduced form factor for the interposer 608.

In the present example, the connector 112 may be connected to the conductive layer 122 of the first package substrate 102 and the conductive layer 134 of the second package substrate 106. The connector 114 may be connected to a conductive layer 614 of the first package substrate 102 and the conductive layer 139 of the second package substrate 106. The connector 604 may be connected to the conductive layer 124 of the first package substrate 102 and a conductive layer 606 of the second package substrate 106. In this way, each of the connectors 112, 114, 604 may electrically and structurally connect the first package substrate 102 to the second package substrate 106.

In the present example, the passive component 602 may be embedded in the dielectric substrate 130 and may include terminals that are respectively coupled to component terminals 610, 612 of the interposer 608. The component terminals 610, 612 may be coupled (e.g., directly connected to) conductive layers 616 (e.g., corresponding to two separate conductive layers) of the second package substrate 106.

The component terminals 610, 612 may be formed on the same side of the dielectric substrate 130. In one or more embodiments, each of the component terminals 116, 118, 612, 610 may be formed on the same side of the dielectric substrate 130, and in contact with the second package substrate 106.

While the interposer 608 is shown to include only two passive components 110, 602, in the present example, it should be understood that this is intended to be illustrative and not limiting. In one or more other embodiments, the interposer 608 may include additional passive components, corresponding component terminals, and connectors (e.g., in addition to the passive components 110, 602, component terminals 116, 118, 610, 612, and connectors 112, 114, 604).

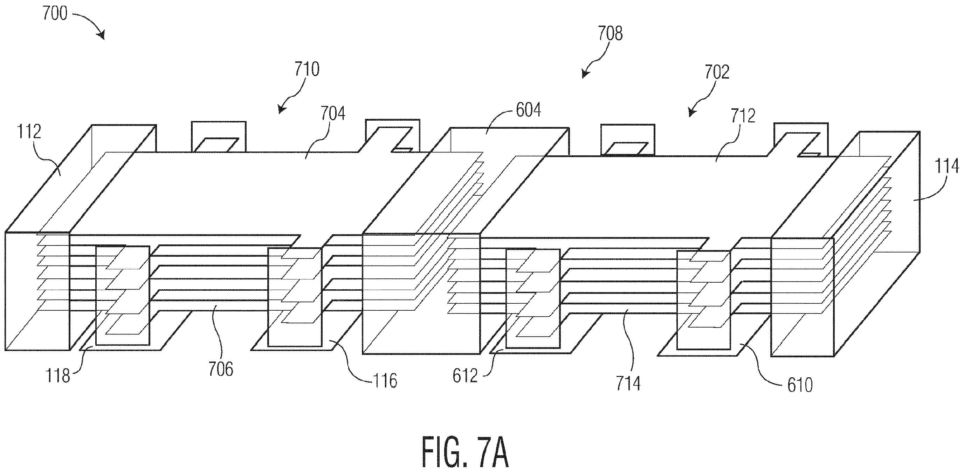

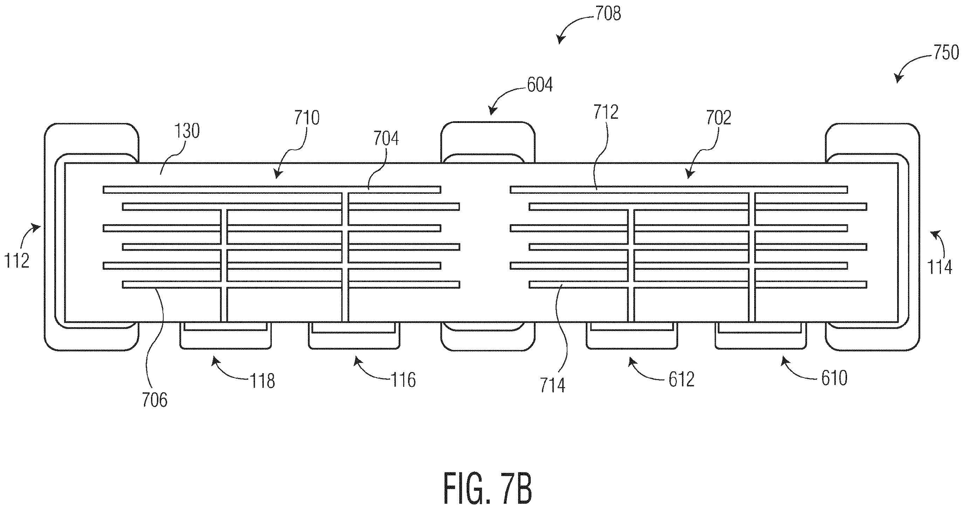

FIGS. 7A and 7B respectively show a partially transparent perspective view 700 and a cross-sectional side view 750 of an interposer 708, which may be an example embodiment of the interposer 608 of FIG. 6. One or more elements of the interposer 708 may be similar to elements of the interposer 108 of FIG. 1 or the interposer 608 of FIG. 6, with like elements being denoted using like reference numerals. Aspects of such like elements that are described above are not necessarily redescribed here for the sake of brevity.

As shown in the views 700, 750, the interposer 708 includes a first capacitor 710 (e.g., an example embodiment of the passive component 110 of FIG. 6) and a second capacitor 702 (e.g., an example embodiment of the passive component 602 of FIG. 6) that are each embedded in the dielectric substrate 130. It should be noted that the dielectric substrate 130 is not shown in the partially transparent perspective view 700 to allow other elements of the interposer 708 to be seen. The capacitor 710 may include a stack of parallel plates that includes a first group of parallel plates 704 and a second group of parallel plates 706 that are arranged in an alternating pattern, such that each of the first group of parallel plates 704 is capacitively coupled to at least one of the second group of parallel plates 706 and vice versa. The capacitor 702 may include a stack of parallel plates that includes a third group of parallel plates 712 and a fourth group of parallel plates 714 that are arranged in an alternating pattern, such that each of the third group of parallel plates 712 is capacitively coupled to at least one of the fourth group of parallel plates 714 and vice versa.

The first, second, third, and fourth groups of parallel plates 704, 706, 712, 714 may each be formed from conductive material, which may be nickel, copper, gold, aluminum, or a combination of these, as non-limiting examples. Each parallel plate of the first group of parallel plates 704 may be electrically connected each other parallel plate of the first group of parallel plates 704 and to the component terminal 116. Each parallel plate of the second group of parallel plates 706 may be electrically connected to each other parallel plate of the second group of parallel plates 706 and the component terminal 118. Each parallel plate of the third group of parallel plates 712 may be electrically connected each other parallel plate of the third group of parallel plates 712 and to the component terminal 610. Each parallel plate of the fourth group of parallel plates 714 may be electrically connected to each other parallel plate of the fourth group of parallel plates 714 and the component terminal 612. As shown, each of the component terminals 116, 118, 610, 612 may be disposed at the same side of the dielectric substrate 130.

The view 700 additionally shows how the connector 604 may wrap around the interposer 708 (e.g., in contact with three or more surfaces of the dielectric substrate 130) in one or more embodiments.

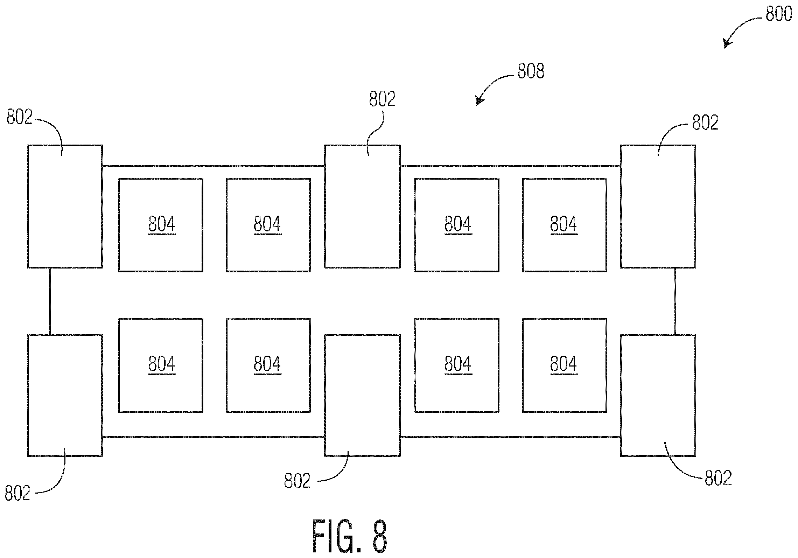

FIG. 8 shows a cross-sectional top-down view 800 of an interposer 808, which may be an example embodiment of the interposer 608 of FIG. 6. As shown, the interposer 808 may include multiple passive components 804 (e.g., eight passive components, in the present example) embedded in a dielectric substrate 806 (e.g., the dielectric substrate 130 of FIGS. 1, 6), and multiple connectors 802 (e.g., six connectors, in the present example) formed on the dielectric substrate 806. Each of the passive components 804 may be coupled to respective pairs of component terminals (e.g., component terminals 116, 118, 610, 612, FIG. 6) each formed on the same side of the dielectric substrate 806. Each of the connectors 802 may be respectively formed on at least three sides of the dielectric substrate 806 and may each span at least the height of the dielectric substrate 806. In this way, when the interposer 808 is disposed between two package substrates (e.g., the first package substrate 102 and the second package substrate 106 of FIGS. 1, 6), each of the connectors 802 may extend between the two package substrates and may electrically and structurally couple the two package substrates together. In one or more embodiments, on or more aspects of the connectors 802 may be similar to those of the connectors 112, 114, 604 of FIGS. 1, 6, described above.

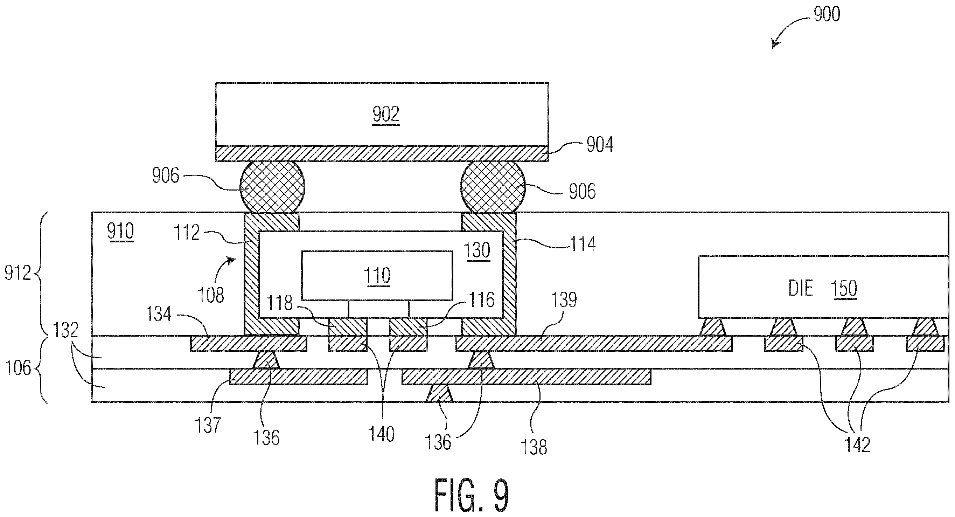

FIG. 9 shows an example package module 900 in which an element 902 is disposed over (e.g., stacked on) a package substrate 106, where at least one interposer 108 is embedded in mold material 910 at a surface of the package substrate 106 in a region 912 between the package substrate 106 and the element 902. One or more elements of the package module 900 may be similar to elements of the package module 100 of FIG. 1, with like elements being denoted using like reference numerals. Aspects of such like elements that are described above are not necessarily redescribed here for the sake of brevity.

In the president example, rather than being disposed between two package substrates, the interposer 108 is disposed in a region 912 over a package substrate 106, where the interposer 108 is embedded in mold material 910, which may be a thermoset epoxy or another suitable type of mold material. In one or more embodiments, other components, such as the integrated circuit die 150, may also be embedded in the mold material 910.

The interposer 108 may be positioned and electrically coupled between the element 902 and the package substrate 106. For example, the connectors 112, 114 of the interposer 108 may act as through-mold vias (TMVs), such that the connectors 112, 114 each extend through the mold material 910. For example, the connector 112 of the interposer 108 may extend between the conductive layer 134 of the package substrate 106 and one of a group of solder balls 906 that is coupled to one or more conductive layers 904 of the element 902. For example, the connector 114 of the interposer 108 may extend between the conductive layer 139 of the package substrate 106 and one of the group of solder balls 906 that is coupled to the one or more conductive layers 904 of the element 902.

In the present example, the element 902 is shown as an integrated circuit die. However, this arrangement is intended to be illustrative and non-limiting. For example, in one or more other embodiments, the element 902 may be a package, a connector, an antenna, a surface mount device (SMD), or another suitable element. In one or more such embodiments, the element 902 may be connected to more or fewer connectors of the interposer 108 than shown in the example of FIG. 9.

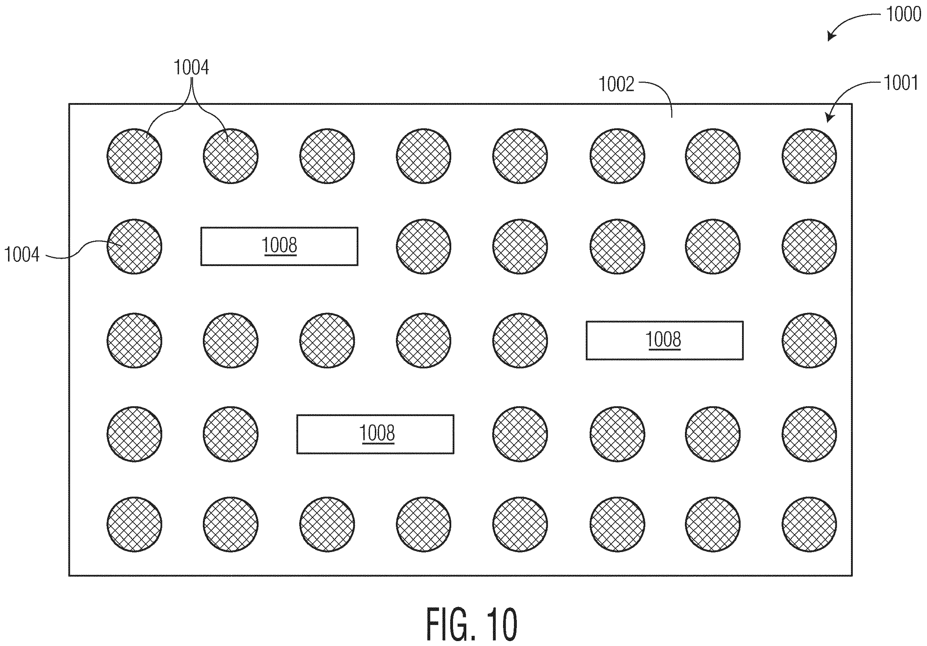

FIG. 10 shows an illustrative cross-sectional top-down view of a package module 1000 that includes a ball grid array 1001 disposed on a package substrate 1002 (e.g., the package substrate 106 of FIGS. 1, 6, 9). The ball grid array 1001 may include solder balls 1004 and one or more interposers 1008.

The ball grid array 1001 may include an array of elements, including solder balls 1004 and interposers 1008, that are arranged on a surface of the package substrate 1002. In one or more embodiments, each element of the ball grid array may be equally spaced apart from adjacent (e.g., not including diagonal adjacency) elements of the ball grid array. For example, the ball grid array 1001 may electrically and structurally connect the package substrate 1002 to another package substrate (e.g., the package substrate 102 of FIGS. 1, 6). Each element of the ball grid array 1001 may be disposed in an inter-package region (e.g., the inter-package region 104 of FIGS. 1, 6) of the package module 1000.

As shown, the ball grid array 1001 may differ from conventional ball grid arrays at least in that not all elements of the ball grid array 1001 are solder balls. Rather, one or more interposers 1008 (e.g., three interposers 1008 in the present example) may be provided in place of solder balls of the ball grid array 1001. In the present example, each of the interposers 1008 replaces two solder balls of the ball grid array 1001, although it should be understood that in one or more other embodiments (e.g., embodiments in which the interposers 1008 each include more than two 3D connectors), additional solder balls may be replaced by each of the interposers 1008. In accordance with various embodiments, the interposers 1008 may correspond to any of the interposers 108, 208, 308, 408, 508, 608, 708, or 808 of FIGS. 1-9, as described above. Similarly to the solder balls 1004, the interposers 1008 may provide electrical and structural connections between the package substrate 1002 and another package substrate (e.g., the package substrate 102 of FIGS. 1, 6) or integrated circuit die (e.g., the element 902 of FIG. 9) bonded thereto via the interposers 1008, while additionally providing functionality of one or more passive components (e.g., the passive component 110 of FIGS. 1, 6, 9; the passive component 602 of FIG. 6; the passive components 804 of FIG. 8; the capacitors 210, 702, 710 of FIGS. 2A, 2B, 3, 7A, 7B; the inductor 410 of FIGS. 4A, 4B; and/or the resistor 510 of FIG. 5) that may be integrated within each of the interposers 1008.

In this way, the interposers 1008 may be included in place of solder balls at selected locations within the ball grid array 1001 to provide passive device functionality at such locations without requiring the ball grid array 1001 to be replaced, in its entirety, with an interposer. This may advantageously improve the design flexibility of the package module 1000.

It should be understood that the arrangement of elements of the ball grid array 1001 is illustrative and not limiting. For example, the ball grid array 1001 is shown to include three interposers 1008 in the present example, it should be understood that more or fewer interposers 1008 may be included in place of solder balls 1004 of the ball grid array 1001 in accordance with one or more other embodiments.

In one or more embodiments, the array 1001 may include only interposers 1008 and the solder balls 1004 may be omitted. In such embodiments, the electrical and structural connections between the package substrate 1002 and another package substrate (e.g., the package substrate 102 of FIGS. 1, 6) or integrated circuit die (e.g., the element 902 of FIG. 9) or other elements may be achieved using only the interposers 1008.

An interposer may include one or more passive components integrated within a dielectric substrate and may include one or more three-dimensional (3D) connectors that surround respective portions of the dielectric substrate. Component terminals of the one or more passive components may each be disposed on the same side of the interposer. For example, the interposer may be disposed between a first package and a second package, such that the connectors of the interposer electrically connect the first package to the second package. The component terminals of the one or more passive components may couple the integrated passive components of the interposer to only one package to which the interposer is coupled.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A package module comprising:
an interposer comprising:
a dielectric substrate;
at least one connector disposed on at least one surface of the dielectric substrate;
at least one passive component embedded in the dielectric substrate; and
at least two component terminals disposed at a same side of the dielectric substrate and coupled to the at least one passive component;
a first substrate disposed on the interposer and in electrical contact with the at least one connector of the interposer; and
a second substrate on which the interposer is disposed, wherein the second substrate is in electrical contact with the at least one connector of the interposer and with the at least two component terminals of the interposer.

2. The package module of claim 1, wherein the at least one connector comprises a first connector disposed on a first surface of the dielectric substrate and a second connector disposed on a second surface of the dielectric substrate that is opposite the second surface, wherein the first connector extends from the first substrate to the second substrate, and the second connector extends from the first substrate to the second substrate.

3. The package module of claim 2, wherein each of the at least two component terminals of the interposer is isolated from the first connector and the second connector of the interposer.

4. The package module of claim 2 or 3, the at least two component terminals of the interposer include a first component terminal and a second component terminal, wherein the first component terminal of the interposer is integrally formed with the first connector of the interposer, and the second component terminal of the interposer is isolated from the second connector of the interposer.

5. The package module of any preceding claim, wherein:
the at least one passive component comprises a first passive component and a second passive component;
the at least one connector comprises a first connector, a second connector, and a third connector; and
the at least two component terminals comprise first and second component terminals coupled between the first passive component and the second substrate, and third and fourth component terminals coupled between the second passive component and the second substrate.

6. The package module of claim 5, wherein:
the first connector is disposed on a first surface of the dielectric substrate;
the second connector is disposed on a second surface of the dielectric substrate that is opposite the first surface; and
the third connector is wrapped at least partially around the dielectric substrate such that the third connector is in contact with third, fourth, and fifth surfaces of the dielectric substrate, which each extend between the first surface and the second surface.

7. The package module of claim 6, wherein:
the first connector extends between a first conductive layer of the first substrate and a first conductive layer of the second substrate, such that the first connector electrically connects the first substrate to the second substrate;
the second connector extends between a second conductive layer of the first substrate and a second conductive layer of the second substrate, such that the second connector electrically connects the first substrate to the second substrate; and
the third connector extends between a third conductive layer of the first substrate and a third conductive layer of the second substrate, such that the third connector electrically connects the first substrate to the second substrate.

8. The package module of any preceding claim, wherein outermost conductive layers of each of the at least one connector and the at least two component terminals each comprise solder.

9. The package module of any preceding claim, further comprising:
a ball grid array comprising a plurality of elements that includes a plurality of solder balls and the interposer, wherein the ball grid array is disposed between the first substrate and the second substrate.

10. A package module comprising:
the interposer of claim 1, wherein the at least one connector comprises a first connector and a second connector and wherein:
the first connector is disposed on a first surface of the dielectric substrate;
the second connector is disposed on a second surface of the dielectric substrate, wherein the second surface of the dielectric substrate is opposite the first surface of the dielectric substrate; wherein the at least one component terminal comprises a first terminal and a second terminal and wherein
the first component terminal is disposed on a third surface of the dielectric substrate and coupled to the at least one passive component; and
the second component terminal disposed on the third surface of the dielectric substrate and coupled to the at least one passive component; and
a first substrate is in electrical contact with the first and second connectors of the interposer.

11. The package module of claim 10, further comprising:
mold material in which the interposer is embedded; and
an integrated circuit die disposed over the mold material, wherein the first package substrate is coupled to the integrated circuit die via the first and second connectors of the interposer.

12. The package module of claim 10 or 11, further comprising:
a second package substrate in electrical contact with the first and second connectors of the interposer and with the first and second component terminals of the interposer, wherein the first connector extends from the first package substrate to the second package substrate, and the second connector extends from the first package substrate to the second package substrate.

13. The package module of claim 12, further comprising:
a third connector that extends between the first package substrate and the second package substrate;
a third component terminal disposed on the third surface of the dielectric substrate;
a fourth component terminal disposed on the third surface of the dielectric substrate; and
a second passive component coupled to the third component terminal and the fourth component terminal; wherein:
the third connector includes portions that directly contact the third surface of the dielectric substrate, a fourth surface of the dielectric substrate, and a fifth surface of the dielectric substrate;
the third, fourth, and fifth surfaces of the dielectric substrate extend between the first and second surfaces of the dielectric substrate; and
each of the first, second, third, and fourth component terminals contact respectively different conductive layers of the second package substrate.

## Amended claims

### Amended claims in accordance with Rule 137(2) EPC.

1. A package module (100, 600, 900, 1000) comprising:
a first substrate (102);
a second substrate (106); and
an interposer (108, 208, 308, 408, 508, 608, 708, 808, 1008) comprising:
a dielectric substrate (130, 806);
at least one connector, comprising at least one three-dimensional connector (112, 114, 604, 802), wherein each three-dimensional connector is disposed on multiple sides of the dielectric substrate to provide a vertical connection between the first substrate and the second substrate to electrically couple the first substrate to the second substrate;
at least one passive component (110, 210, 410, 510, 602, 702, 710, 804) embedded in the dielectric substrate; and
at least two component terminals (116, 118, 610, 612) disposed at a same side of the dielectric substrate and coupled to the at least one passive component;
wherein the first substrate is disposed on the interposer and in electrical contact with the at least one three-dimensional connector; and
wherein the interposer is disposed on the second substrate, and wherein the second substrate is in electrical contact with the at least one three-dimensional connector and with the at least two component terminals of the interposer.

2. The package module of claim 1, wherein the at least one connector includes a first connector disposed on a first surface of the dielectric substrate and a second connector disposed on a second surface of the dielectric substrate that is opposite the second surface, wherein the first connector extends from the first substrate to the second substrate, and the second connector extends from the first substrate to the second substrate.

3. The package module of claim 2, wherein each of the at least two component terminals of the interposer is isolated from the first connector and the second connector of the interposer.

4. The package module of claim 2, the at least two component terminals of the interposer include a first component terminal and a second component terminal, wherein the first component terminal of the interposer is integrally formed with the first connector of the interposer, and the second component terminal of the interposer is isolated from the second connector of the interposer.

5. The package module of any preceding claim, wherein:
the at least one passive component comprises a first passive component and a second passive component;
the at least one connector comprises a first connector, a second connector, and a third connector; and
the at least two component terminals comprise first and second component terminals coupled between the first passive component and the second substrate, and third and fourth component terminals coupled between the second passive component and the second substrate.

6. The package module of claim 5, wherein:
the first connector is disposed on a first surface of the dielectric substrate;
the second connector is disposed on a second surface of the dielectric substrate that is opposite the first surface; and
the third connector is a three-dimensional connector that is wrapped at least partially around the dielectric substrate such that the third connector is in contact with third, fourth, and fifth surfaces of the dielectric substrate, which each extend between the first surface and the second surface.

7. The package module of claim 6, wherein:
the first connector extends between a first conductive layer of the first substrate and a first conductive layer of the second substrate, such that the first connector electrically connects the first substrate to the second substrate;
the second connector extends between a second conductive layer of the first substrate and a second conductive layer of the second substrate, such that the second connector electrically connects the first substrate to the second substrate; and
the third, three-dimensional, connector extends between a third conductive layer of the first substrate and a third conductive layer of the second substrate, such that the third connector electrically connects the first substrate to the second substrate.

8. The package module of any preceding claim, wherein outermost conductive layers of each of the at least one connector and the at least two component terminals each comprise solder.

9. The package module of any preceding claim, further comprising:
a ball grid array (1001) comprising a plurality of elements that includes a plurality of solder balls (1004) and the interposer, wherein the ball grid array is disposed between the first substrate and the second substrate.
